(19) Europäisches Patentamt

European Patent Office

Office européen des brevets

(11) **EP 2 848 947 A1**

(12) **EUROPEAN PATENT APPLICATION**

(43) Date of publication:
18.03.2015 Bulletin 2015/12

(51) Int Cl.:
*G01R 19/25* (2006.01)    *G01R 29/18* (2006.01)

(21) Application number: 14184664.2

(22) Date of filing: 12.09.2014

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(30) Priority: 12.09.2013 AT 505752013

(71) Applicant: Fluke Corporation
Everett, WA 98203 (US)

(72) Inventor: Svasek, Maximilian
1230 Wien (AT)

(74) Representative: Clarke, Jeffrey David
HGF Limited
Fountain Precinct
Balm Green
Sheffield S1 2JA (GB)

(54) **Method and Device for Measuring Electrical Quantities**

(57)    A method and device for measuring electrical quantities, at least voltage and current, preferably also power, in three-phase systems wherein the phase voltages and phase currents in the phase lines of a three-phase system are sensed by voltage and current sensors connected to the phase lines. Corresponding voltage and current signals are evaluated by a processor to form measurement data that are displayed on a display. Relative phase positions of the voltage signals and the current signals are compared with a given phase sequence and therefrom a correctness or incorrectness of the connections of the voltage and current sensors to the phase lines is determined, and corresponding display signals are output to the display. In response to determining that one or more voltage or current sensors are incorrectly connected to the phase lines, an automatic and electronic correction comprising inversion and/or exchange of the measurement data may be provided.

Fig. 1

**Description**

FIELD

The present disclosure refers to a method for measuring electrical quantities, at least voltage and current, preferably also power, in three-phase systems.

BACKGROUND

In three-phase power supply systems, it is known to measure the voltages of the three phases as well as the three currents flowing through the phase lines, wherein, via a corresponding combination of the related voltages and currents, the power and/or the energy can also be determined phase-wise. In this connection, the various characteristic values of the power may be determined, namely, active power, reactive power and apparent power. From apparent power and active power, the power factor $\cos\varphi$ can be determined in a known manner.

One problem with the hitherto existing measuring techniques is that when voltage sensors and current sensors are connected to the phase lines, errors can occur in the connections. For instance, a current probe may be arranged around a phase line the wrong way so that a false current direction will be determined, or the voltage sensors and current sensors may not be connected respectively in correct pairs to the three phases, but instead, for instance, two current sensors, e.g., for the second and third phase, are interchanged so that incorrect powers and also negative powers can result during power determination.

BRIEF SUMMARY

Embodiments of the present disclosure provide a technique by way of which incorrect or faulty connections can be detected quickly and safely and, subsequently, can preferably also be electronically corrected. Embodiments of the present disclosure also help ensure that, with the aid of previous tests, only reasonable measurements are determined, at least as far as the level of the voltage and current and a defined maximum deviation from a nominal system frequency are concerned. An allocation of voltage and current to the correct phase (sense of rotation - phase sequence) may also be provided.

Accordingly, the relative phase positions of the voltage signals as well as the current signals are evaluated in comparison with a given phase sequence, and the correctness or incorrectness of the connections of the voltage and current sensors to the phase lines are determined therefrom, wherein corresponding display signals for a display are output.

In a corresponding manner, a processor may be arranged to determine the relative phase positions of the voltage signals as well as the current signals in comparison with a given phase sequence, and to determine therefrom the correctness or incorrectness of the connections of the voltage and current sensors to phase lines, as well as to output corresponding display signals for a display.

As far as the correctness of the connections of the voltage and current sensors is concerned, in a three-phase system the directions of rotation for the phase voltages and phase currents, respectively, can be determined. To this end, difference angles between the individual phase voltages or between the individual phase currents may be determined. The determination of the difference angle is preferably provided a given bandwidth (margin), e.g., ±50°, in connection with a nominal phase angle, e.g., +120° and -120°, of the three-phase system.

Based on the voltage and current measurement data, a power calculation for each phase can be performed, wherein also the respective phase sequences are taken into account, and preferably the calculated powers will be displayed in connection with a corresponding phase sequence indication (correct phase sequence or reversed phase sequence). As far as the correct power calculation is concerned, the active power, the reactive power, and the apparent power can be calculated, respectively, and moreover, if desired, harmonic components can also be calculated via a Fast Fourier Transformation (FFT). Furthermore, in the power calculation, it can be taken into account whether a load operation (consumer operation) or a generator operation (e.g., by a connection of a photovoltaic system) is given.

To ensure reasonable measurements, the sensed voltages and/or currents are preferably compared beforehand with a given minimum threshold value, and subsequently, evaluations will only be carried out when the sensed voltages and/or currents exceed the threshold value. In a similar manner, frequency checks for the phase voltages and currents can be performed, i.e., it is checked whether a defined maximum deviation from a nominal system frequency is present in the sensed voltages or currents (e.g., 50 Hz or - in the USA - 60 Hz). The check of the given nominal frequency is carried out within a defined frequency range around the nominal frequency.

Furthermore, for the power analysis, it is also expedient to determine the current flow direction for each phase, in order to thus detect any current sensors that are mounted the wrong way. Current sensors that are attached the wrong way will result in a reversed energy flow in the individual phase powers (generator and consumer power are interchanged).

In case of a faulty connection of one or more sensors to a phase line, in the present disclosure, a "correction" in the sense of an exchange of data can also be carried out, without any physical change of the sensor connection directly at the phase line, by, for instance, simply exchanging the measurement data of two phases, in order to thus produce a correct phase sequence. This correction can be carried out electronically and automatically by a processor.

The present disclosure will be explained in more detail in the following, in particular, for three-phase systems in a star or wye ("Y") connection. The present disclosure can also be applied in the same manner to a three-phase system in a delta connection ("Δ" connection) in which there is no star point. In this case, reference will be made to a vectorial mid-potential, instead of having available a star point, i.e., a neutral line, directly as a reference point.

DESCRIPTION OF THE DRAWINGS

In the following, various embodiments of the invention will be described with reference to the drawings, in which:

FIGURE 1 shows a block diagram of a device for measuring electrical quantities in the form of a multifunction measuring instrument;

FIGURE 2 shows a general flow diagram for checking the correctness of the connections of the sensors of the measuring instrument to the phase lines;

FIGURES 3 and 4 show partial flow diagrams for validating the voltage or the current for the purpose of checking whether a measurement basically makes sense;

FIGURE 5, in a partial flow diagram, illustrates a step shown in the diagram according to FIGURE 2 for analysis of the voltage rotation (direction of rotation of the voltage);

FIGURE 6, in the partial FIGURES 6a and 6b that are considered to be joined together, shows a corresponding analysis of the current rotation in a partial flow diagram;

FIGURE 7, in the partial FIGURES 7a and 7b, shows the composition of a general three-phase phasor system by way of three components (FIGURE 7a), namely, with a positive direction of rotation (a so-called "positive-sequence system"), with a negative direction of rotation (a so-called "negative-sequence system"), and with a mere displacement or offset;

FIGURE 8 shows a detailed flow diagram for a consumer-system power analysis generally illustrated in FIGURE 2; and

FIGURE 9 shows in a corresponding detailed flow diagram for a generator-system power analysis according to FIGURE 2.

DETAILED DESCRIPTION

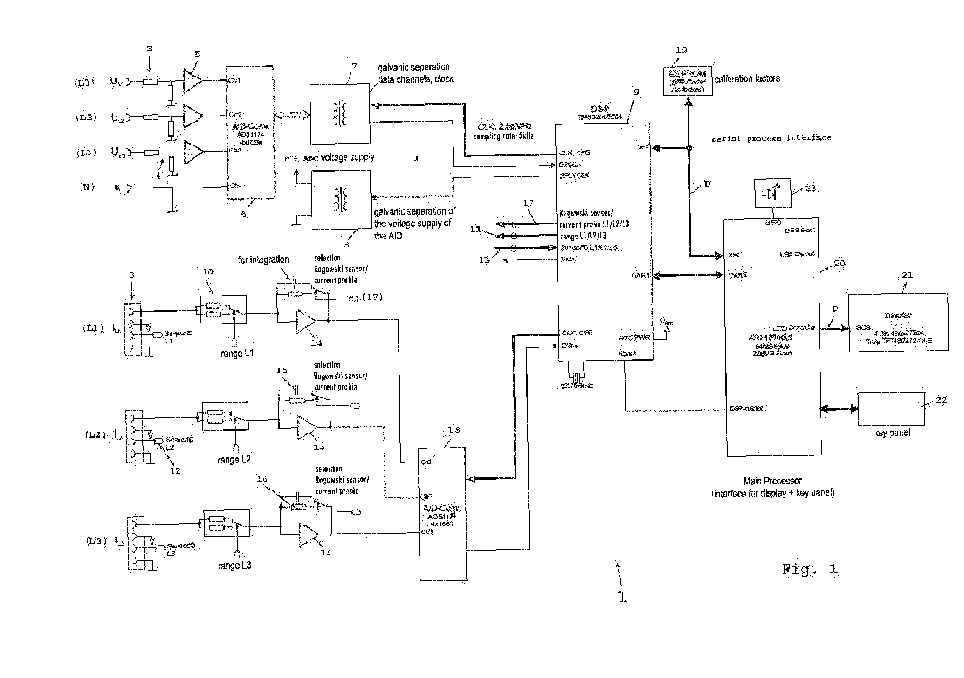

FIGURE 1 schematically shows a measuring instrument 1, i.e., a device for measuring electrical quantities, namely voltage and current, and preferably also for calculating the power and power factor in a three-phase system. The three phases of the three-phase system are referred to as L1, L2, and L3, wherein these designations will also be used for the actual phase lines. Furthermore, FIGURE 1 also indicates, in the range of the voltage measurement, a neutral-to-ground potential or starpoint voltage $U_N$ that is allocated to the neutral line, neutral or zero point, or star point.

For measurement of the voltages $U_{L1}$, $U_{L2}$, and $U_{L3}$, and the currents $I_{L1}$, $I_{L2}$, and $I_{L3}$, voltage and current sensors 2 and 3 are provided. In the illustrated embodiment, the voltage sensors 2 are provided with a voltage divider 4, respectively, wherein at the branch point of the latter, a respective amplifier 5 is connected. In accordance with the three phases L1, L2, and L3, there are given three channels, wherein, corresponding to these three channels, the outputs of the amplifiers 5 are connected with three channel inputs Ch1 Ch2, and Ch3 of an A/D converter 6.

The voltage measuring unit 2, 4, 5, and 6 described so far is galvanically isolated 7, 8 from the rest of the measuring instrument 1 by way of transformers, in order to be able to supply, on the one hand, clock signals or control signals from a digital signal processor 9, which is provided as a processing means 9, via the upper galvanic separation 7, as shown in FIGURE 1, to the A/D converter 6, or to supply from the A/D converter 6, via the galvanic separation 7, signals from the A/D converter 6 to the digital signal processor 9 (in the following briefly called DSP 9). On the other hand, the voltage supply of the voltage sensor unit, in particular of the A/D converter 6, but also of the amplifiers 5, is realized via the lower galvanic separation 8 in FIGURE 1. Thereby it is taken into account that the neutral line N can be at a potential differing from the rest of the measuring device 1. For the three voltage channels, the neutral line N is the reference point in case of a wye connection of the three-phase system, i.e., there is provided a connection to the star point of the power or mains supply. In the case of a delta connection, there is no star point, but a vectorial mid-potential will ensue in the three phases, and said mid-potential will serve as a reference potential.

The three voltage channels with the three input voltages $U_{L1}$, $U_{L2}$, and $U_{L3}$ are synchronously sampled via the voltage sensors (dividers) 2 and the buffer amplifiers 5 by the A/D converter 6, for instance, with a sampling rate of 5 kHz. The corresponding signal data is then transferred separately via the galvanic separation 7 to the DSP 9.

The current sensors 3 can be of any type. For example, Rogowski sensors that provide a differentiated signal may be employed. As current sensors 3, instance shunts and conventional current probes can also be used. As shunts also lie at a high potential for the current-voltage conversion, the current measuring element has to be galvanically isolated, which, however, is not necessary to further explain here. The currents $I_{L1}$, $I_{L2}$, and $I_{L3}$ can have a high dynamic, and accordingly, for each current measuring channel, a range-change switch or band switch 10 may be provided that can be controlled independently from the others by the DSP 9 via control lines 11. Furthermore, each current sensor 3 may have its own memory element 12 that contains data concerning the sensor type, the amplification, the phase position, and further parameters, in order to increase the accuracy of measurement, and said "Sensor ID" data will be read in by the DSP 9 via a bus 13.

As a precaution it should be pointed out that, in contrast to the voltage channels, the three current channels with the current sensors 3 do not require a galvanic separation, as the preferably used current sensors 3, namely, a Rogowski coil or a current probe, already ensure a galvanic separation due to the principle of measurement.

Accordingly, depending on the sensor type, a switching-over or change-over in the range of an operational amplifier 14 downstream of the respective range-change switch 10 is carried out, in order to provide an integration in the case of Rogowski sensors as current sensors 3, or a simple amplification in the case of current probes as current sensors. See the amplifiers 14 in the individual current measuring channels, with the switchable elements in the feedback branch, namely, a capacitor 15 (for an integration in the case of Rogowski sensors) and a resistor 16 (in the case of current probes as current sensors 3). The switching-over or change-over is triggered by the DSP 9 via corresponding control lines 17. Subsequent thereto, the thus-obtained current signals are in turn supplied to an A/D converter unit 18 with three channels, and therein the current signals will be converted into digital signals synchronously with each other as well as also synchronously to the voltage samplings in the A/D converter 6. The digital current signals are supplied to the DSP 9.

The present device 1 does not comprise analog settings for the balancing of the measured-value channels. Calibration data, see memory 19, will be used for calibrating the voltage channels such that a defined reference voltage is applied to the voltage channels, wherein the reference voltage preferably lies near the final value of the measuring range. The reference voltage is compared with the respective measured effective value of the voltage, said effective value being calculated on the basis of the values of the A/D converter 6.

On the other hand, as already mentioned, the data of the current sensors 3 are input respectively into a plug memory element 12, wherein, apart from the calibration and amplification factor, the type of the current sensor 3, as well as the final value of the measuring range and the respectively supported range, are also stored. Thus, the measuring device 1 can directly take into account the sensor type and the characteristic of the sensor 3. In the case of a current probe being the current sensor 3, the sensor signal is evaluated directly. In the case of Rogowski sensors, the signal will additionally be integrated in order to correctly map the original input signal differentiated by the Rogowski sensor. A configuration at the measuring device 1 itself is not required.

For alternating currents, the amplification factor suffices for the calibration. Additionally, the phase angle of the respective sensor is stored during the calibration, as, especially in the case of current probes, the phase angle can be different due to the magnetic characteristic of each current probe. As the phase angle for the active-power measurement is included directly via the $\cos\varphi$ ($P=U*I*\cos\varphi$), the phase angle is also of importance for an accurate active power measurement. The same applies also to the reactive power, that is $Q=U*I*\sin\varphi$ (note, only the apparent power $S=U*I$ is independent of the phase angle $\varphi$).

In case of a direct-current calibration, in addition to the amplification factor, a zero correction (offset) is also important. This is measured after the input voltage is shorted by the A/D converter 6, and the result is then stored as an offset in the calibration memory 19.

For reasons of safety, the respective current sensor ID can be checked by the DSP 9 at specified intervals, e.g., every 5 seconds, in order to find out whether there was an exchange of sensors.

Thereafter, the DSP 9 further processes the digitized values for the three voltage channels and the three current channels.

A main processor 20 forms the interface to a display 21 that is provided as a display means 21, as well as to a key panel 22, and is equipped with a visual display unit 23, for instance with an LED, in order to send out flashing light signals or steady light signals depending on the state of operation. Apart therefrom, the main processor 20 can also take over signal processing tasks so that a distributed signal processing in combination with the DSP 9 is obtained. For instance, the main processor 20 can form longer averaging intervals from the 200ms packets that it receives from the DSP 9.

The arrangement of keys on the key panel 22 renders it possible, for instance, to influence the indication on the display 21 and, thus, to select different events for indication.

In this connection, for instance, the power factor calculated from the active power and the apparent power can also be indicated for each respective phase.

The corresponding sensor-type data are supplied to the DSP 9, as mentioned above, and the parameters are taken into consideration in the signal processing, wherein a high accuracy can be obtained without the use of analog actuators or the like. In principle, the sensor types and the measuring ranges can be adjusted automatically, depending on which current sensor 3 is currently connected.

As already mentioned, the current signals and voltage signals are all sensed synchronously. The simultaneous sensing of the current and voltage channels is significant for the power calculation, since the phase position of voltage to current is of substantial importance in the active power calculation.

On the display means provided by the display 21, the following indications, for instance, may be displayed: voltage and current per phase, direction of rotation of the phase, current flow direction, and congruence with the pertaining current input. In the course of this, information regarding whether the sensors are correctly connected is directly received.

The following indications can be provided in detail:

Voltage:

- if the voltage value lies below a threshold value, the voltage value will be displayed in a special way, e.g., in red;
- if one of the displayed voltage values is indicated in this manner as being too low, or when there is no indication of the direction of rotation, neither in the clockwise direction nor in the counter-clockwise direction, a symbol, e.g., "X", for an impossible result will be shown in the result column; and
- the minimum threshold value can also be indicated, for instance, 1/20 of the range of the effective voltage.

Current:

- the current value of a particular phase will be indicated by way of an arrow pointing upwards (e.g., a black arrow), if the active power in this phase is positive;
- the current value of the particular phase will be indicated by an arrow pointing downwards (e.g., a red arrow), if the effective power in this phase is negative;
- if the current value lies below a given minimum threshold value, a no current flow and no phase circulation arrow will be indicated; and
- the minimum threshold value is, for instance, 1/150 of the measuring range of the effective value of the current.

Indication of the direction of rotation:

- an (e.g., black) arrow in the clockwise direction will be displayed if the direction of rotation is positive;
- an (e.g., red) arrow in the counterclockwise direction will be displayed if the direction of rotation is negative; and
- a cross or a similar special character will be displayed if the direction of rotation is unknown or if the signal is too weak.

Power:

- the active power in the three phases "a" (L1), "b" (L2), and "c" (L3) will be displayed depending on the topology; and
- if the active power is negative, this will be particularly emphasized on the display, for instance by the addition of a "-". Furthermore, the effective power can be represented in colors, for instance red, if the power flow direction does not correspond to the chosen load or generator operation.

Feedback:

- if no error is detected, this will be correspondingly indicated, for instance, by the indication "No error detected";
- if the signals are too weak, it will be displayed. For example:

    ◦ Voltage in phase x is too low - check connection;
    ◦ Current in phase x is too low - check connection or use a sensor with a smaller range; and

- if a correction (switching-over or change-over) for the voltage and the current is possible, this will be indicated together with a request for an automatic correction. See also the following table 2 as an example.

In the following description, possible indications on the display 21 will be represented in two tables, namely, table 1 and table 2, wherein table 1 represents a measurement free from errors, whereas in table 2, for instance, the phases L2 and L3 are interchanged in the current sensors.

Table 1

| A(L1) | B(L2) | C(L3) | **Result** |
|-------|-------|-------|--------|
| 127.2 v | 122.6 v | 123.5 v | |
| ▲0.888 kA | ▲1.059 kA | ▲1.085 kA | |
| 108.8 kW | 133.9 kW | 112.3 kW | ▲ Consumer ▼ Generator |

No error detected.

Table 2

| A(L1) | B(L2) | C(L3) | Result |
|-------|-------|-------|--------|
| 127.2 v | 122.6 v | 123.5 v | |
| ▲0.888 kA | ▼1.059 kA | ▼1.085 kA | |
| 108.8 kw | -108.8 kW | -112.3 kW | ▲ Consumer ▼ Generator |

Detected phase sequence:

| | | | |
|---|---|---|---|
| Voltage: | 1-L1 | 2-L2 | 3-L3 |
| Current: | 1-L1 | 2-L3* | 3-L2 |

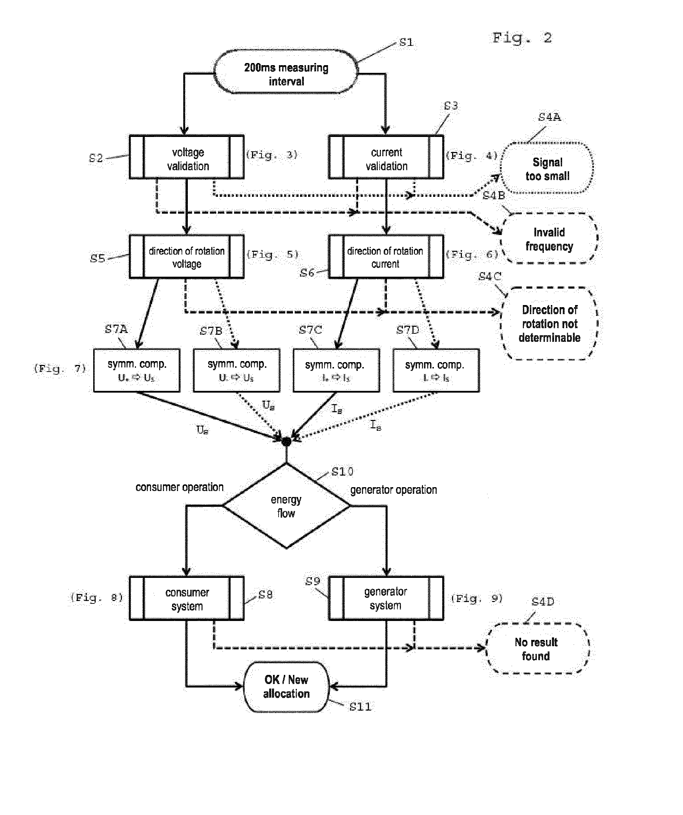

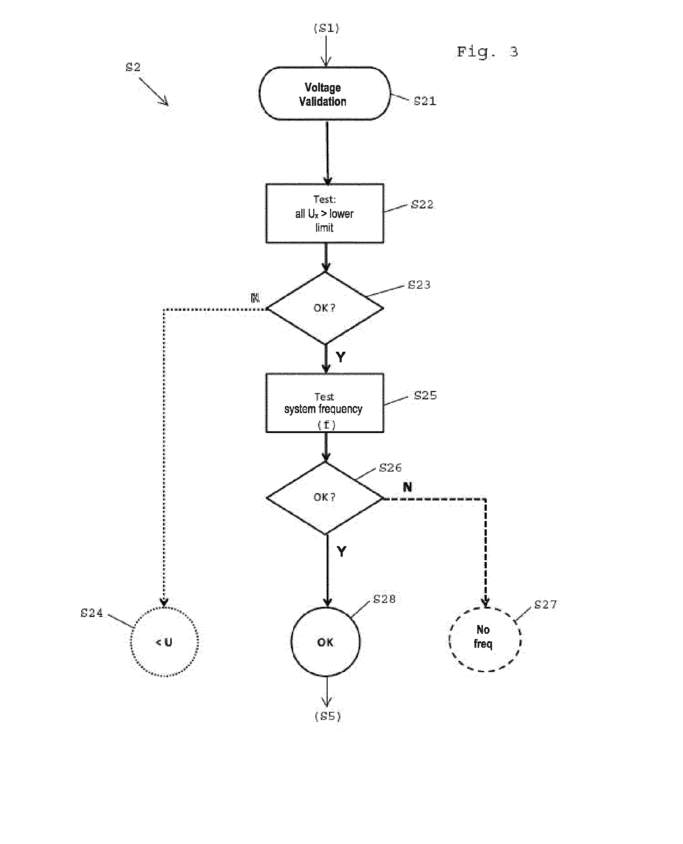

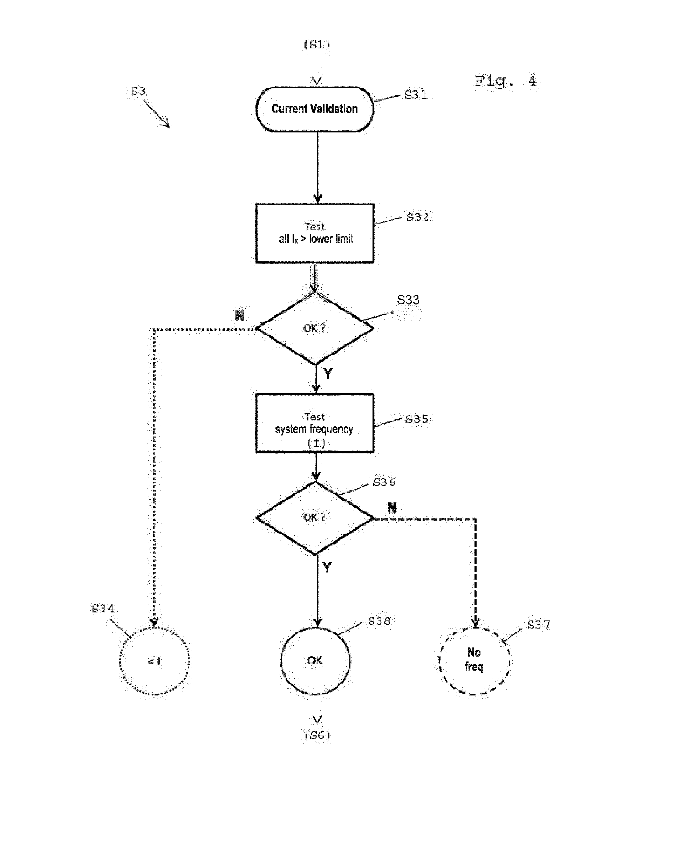

FIGURE 2 illustrates, in a general way, a flow diagram for checking the correctness of the connection configuration, i.e., of the connection of the sensors 2, 3 with the individual phases or phase lines L1, L2, and L3 (in the following also referred to as A, B, and C). As already indicated, the corresponding calculation processes start every 200ms, as is indicated in FIGURE 2, with the introductory initial step S1. Then two steps S2, S3 follow in which it is determined whether a reasonable measurement can or should be carried out with regard to the magnitude of the voltage and the current. In detail, in step S2, a voltage validation is carried out, and in step S3, a current validation is carried out. The manner in which the validations will be carried out is explained in more detail in the following by way of FIGURE 3 (voltage validation) and FIGURE 4 (current validation).

If, in steps S2 or S3, the result is that the signal (voltage or current) is too small or that an invalid frequency is present, further calculation will be stopped and corresponding indications on the display 21 will be shown, as referenced in steps S4A and S4B in FIGURE 2.

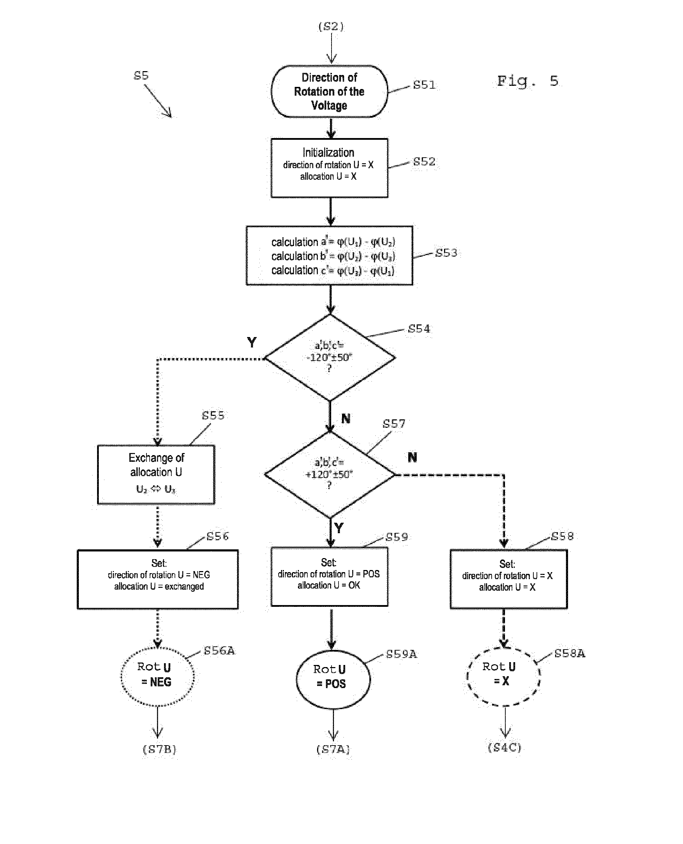

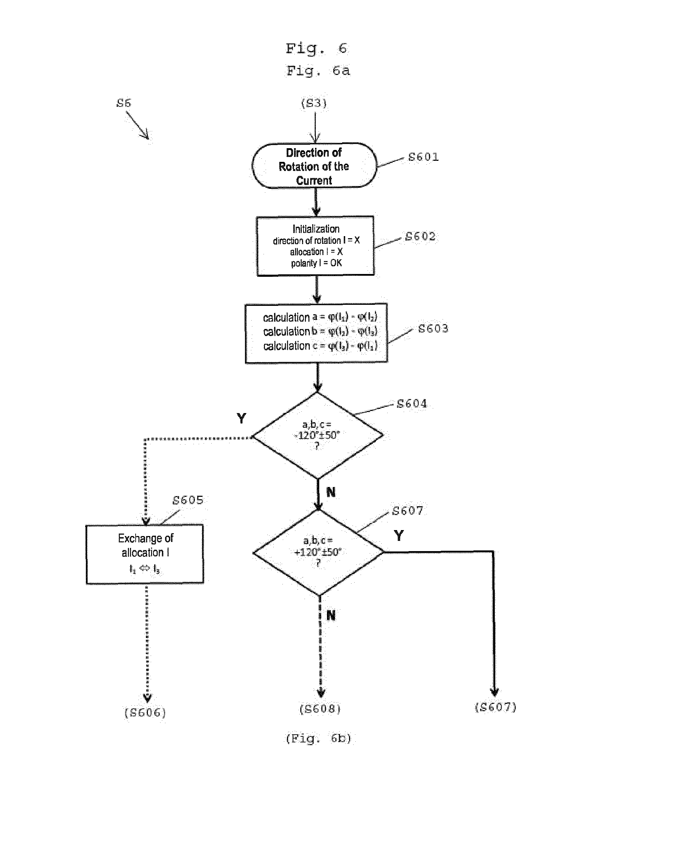

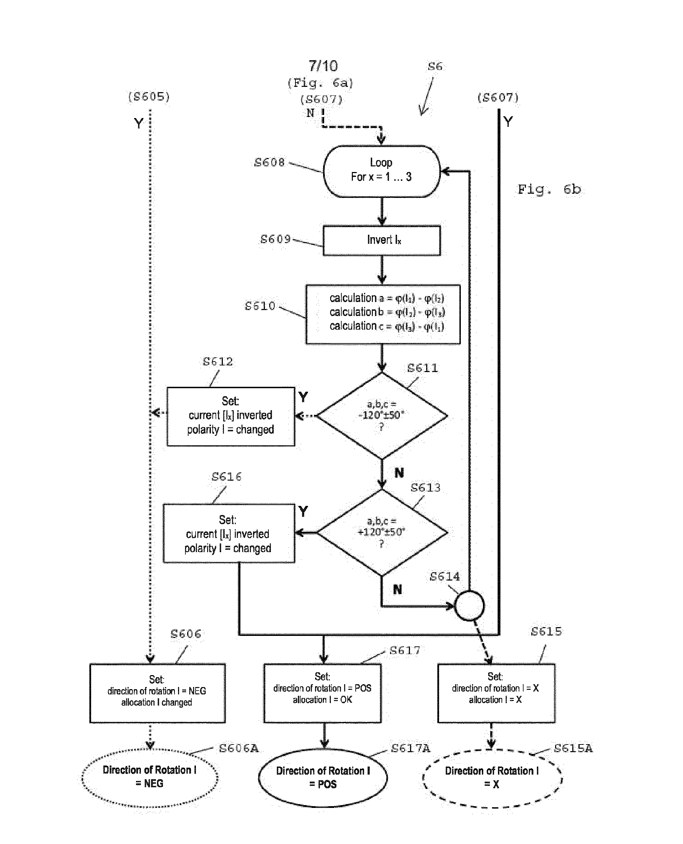

When the voltage signal or the current signal is deemed to be correct, the direction of rotation of the phase voltages (step S5, see also FIGURE 5) and the direction of rotation of the phase currents (step S6, see also FIGURE 6) will be checked.

If, in said checks according to steps S5 and S6, a direction of rotation cannot be determined, this will also be indicated on the display 21, as referenced in step S4C.

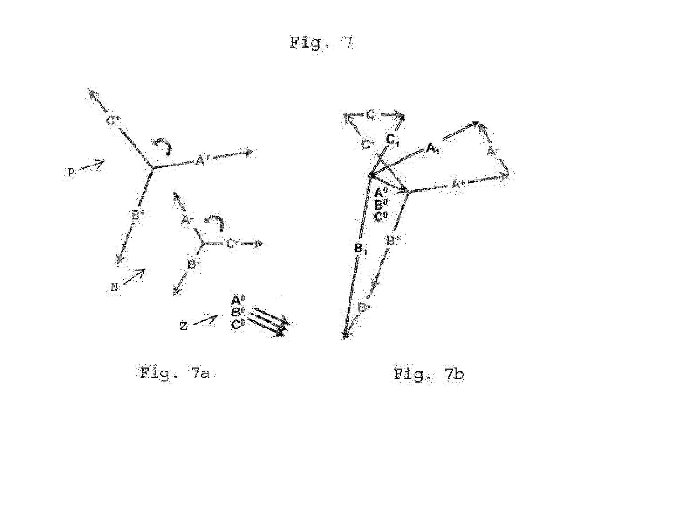

Then, according to steps S7A to S7D, a so-called component analysis (decompensation) is carried out, as referenced in FIGURE 7 (FIGURES 7a, 7b), wherein positive and negative voltage and current components $U_+$, $U_-$ and $I_+$, $L$ are determined, for which the variables $U_s$ and Is are set in the course of the further calculations, according to FIGURE 2.

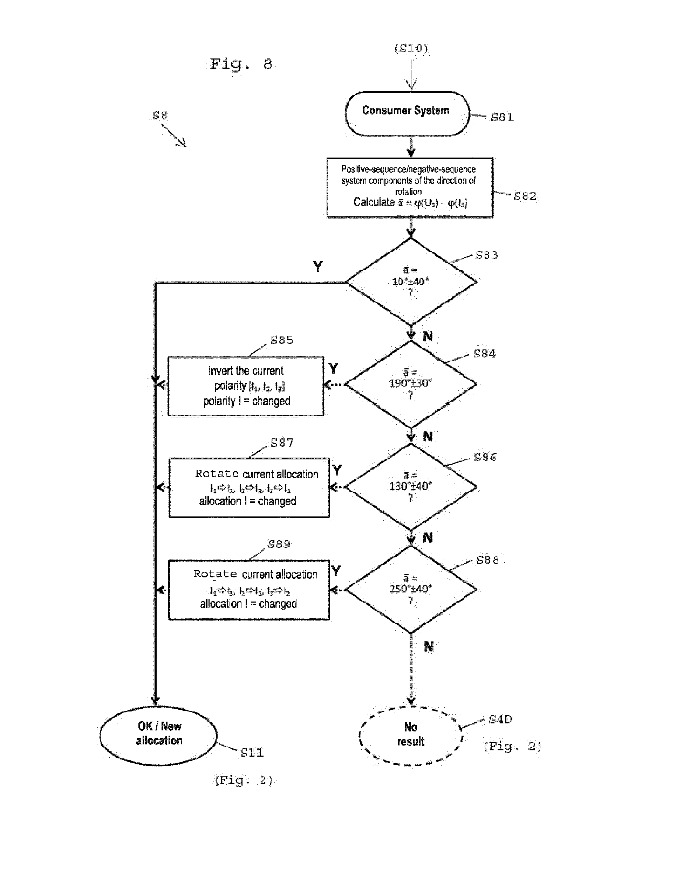

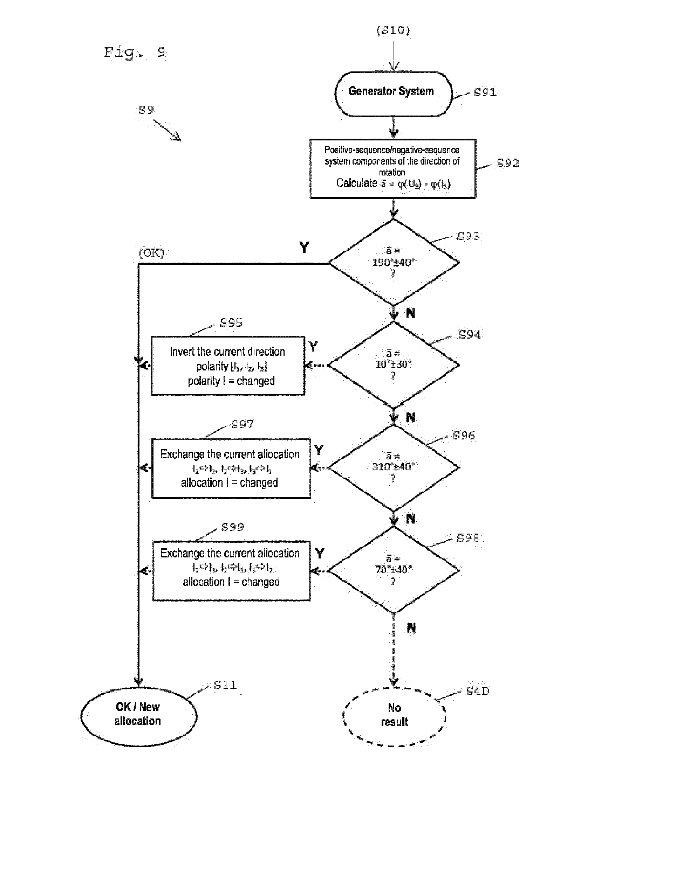

Then, according to the steps S8 and S9 in FIGURE 2, a respective power analysis is carried out, depending on whether the system connected to the three-phase mains is a consumer system (step S8, see also FIGURE 8) or is a generator system (step 9, see also FIGURE 9). To this end, according to step S10, it is manually input whether there is given a consumer operation or a generator operation.

If, from the respective power analysis in step S8 or step S9, no result can be determined, notification is made according to step S4D, and further calculations are stopped. Otherwise, if, as will be explained in the following in more detail by reference to FIGURE 8 and FIGURE 9, corresponding power values can be allocated, this will be displayed together with the corresponding power values on the display 21 according to step S11.

By way of the processing means 9, i.e., of the DSP 9, after an initial step S21 for "voltage validation," the individual respective phase voltages $U_X$ are compared with a minimum threshold value ("lower limit"), as referenced in step S22 and as illustrated in FIGURE 3 which illustrates the processes in step S2 according to FIGURE 2. If it ensues from the corresponding query, step S23, that this is not the case, but that at least one phase voltage is lower than the minimum threshold value, this will be indicated on the display 21 according to step S24, and the further calculations will be stopped. If, however, the phase voltages $U_X$ lie within an acceptable range, it will be checked next according to step S25 whether the phase voltages deviate by a defined maximum deviation from a nominal system frequency (f). If, according to decision step S26, the result thereof is negative, it will be displayed according to step S27 that no reliable frequency is present, and further processing will be stopped. If, however, the measured system frequency (f) is within the given limit, this will be recorded correspondingly according to step S28, and the calculations will continue according to step S5 (FIGURE 2).

In a corresponding manner, the steps illustrated in detail in FIGURE 4 are carried out in the course of the current validation, as referenced in step S3 in FIGURE 2. After an initial step S31, as shown in FIGURE 4, it is checked once again in step S32 whether all phase currents $I_X$ lie above a lower threshold value, and in decision step S33, whether this is the case or not. If even only one phase current $I_X$ lies below the lower threshold value, this will be indicated on the display 21 according to step S34, and the calculation processes will be terminated, as referenced in step S4A in FIGURE 2.

If, however, all phase currents lie above the lower threshold value, then according to step S35 it is checked whether the phase currents deviate by a defined maximum deviation from a nominal system frequency (f). If not, see step S36, exit N, as this will be displayed once again according to step S37, and the further determinations are terminated. If the system frequency is present, this will be indicated according to step S38, and the signal processing will continue according to step S6 in FIGURE 2.

The voltage validation according to FIGURE 3 and the current validation according to FIGURE 4 can be carried out successively or in parallel to each other, depending on the design of the processing means, i.e., the digital signal processor 9. Parallel processing is preferred, as indicated schematically in FIGURE 2.

FIGURE 5 illustrates in detail the analysis of the check of direction of rotation of the voltage according to step S5 in FIGURE 2. After an initial step S51, there follows an initialization step S52, wherein the direction of rotation of the respective phase voltage U is set to be equal to the variable X. Then the difference angles a', b', and c' are calculated according to step S53 in FIGURE 5, i.e.,

$$a'=\varphi(U_1)-\varphi(U_2)$$

$$b'=\varphi(U_2)-\varphi(U_3)$$

$$c'=\varphi(U_3)-\varphi(U_1).$$

Thereupon it will be checked, either by parallel processing or successive processing in a loop, whether the difference angles a', b', and c' are equal to -120° $\pm$ a margin of 50°, as referenced in step S54 in FIGURE 5. If this is true, then a negative direction of rotation of the phases is present, and the allocation of the actual phase voltages $U_2$ and $U_3$ will be exchanged according to step S55. Following step S55, indications that the direction of rotation for the voltage phases is negative and that the voltage allocation was electronically exchanged are recorded according to step S56, and according to step S56A, a corresponding indication that the direction of rotation of the voltage is "Rot U = NEG" is shown on the display 21.

If, however, the result of the query according to step S54 is negative, i.e., there is no negative direction of rotation, according to a query step S57 it is checked whether the respective difference angles a', b', and c' are equal to +120° $\pm$50°. If this does not apply, then according to step S58, it will be determined that the direction of rotation of the voltage is inadmissible (=X), and for the indication thereof there will also be carried out a corresponding allocation of X to U, whereupon, according to step S58A, a corresponding indication of "Rot U = X" will be displayed on the display 21.

If, however, the result of the query in step S57 is positive, then the direction of rotation of the voltage is determined to be admissible, i.e., positive and practicable, as referenced in step S59, whereupon a corresponding indication that the direction of rotation for the voltage is positive and that the allocation of the voltage values is acceptable will be displayed according to step S59A ("Rot U = POS"). Depending on the results displayed in steps S56A, S59A, and S58A, the next position in the diagram according to FIGURE 2 will now be step S7B, S7A, or S4C.

The analysis of the direction of rotation of the current according to FIGURE 6 (which is, in detail, composed of FIGURE 6a and FIGURE 6b) is more complex due to the fact that the current sensors not only can be connected to the incorrect phase, they can also be connected incorrectly to the perhaps correct and pertinent phase such that a wrong direction of current flow will result therefrom.

In the analysis of the direction of rotation of the current, the first steps S601 to S607 are comparable to the steps S51 to S57 according to FIGURE 5. After an initial step S601 and an initialization step S602 with the variable allocation I = X as well as, in addition, the initialization of the polarity, a calculation of the individual phase difference angles $a=\varphi(I_1)-\varphi(I_2)$, $b=\varphi(I_2)-\varphi(I_3)$, and $c=\varphi(I_3)-\varphi(I_1)$ is carried out S603.

Then, according to a step S604, it is once again checked whether the difference angles a, b, and c are equal to -120° ±50° (in accordance with the margin), and if yes, then this will be determined according to step S605 as a mix-up of the connections. According to step S606 in FIGURE 6b, the direction of rotation of the current will be set as negative and the current allocation will be changed, whereupon according to step S606A, it will be indicated that the direction of rotation of the current is negative.

If the query according to step S604 shows that none of the difference angles a, b, and c is equal to the angle -120° ±50°, and that no interchange of the current sensors 3 relative to the phases L1, L2, and L3 is given, then, similar to step S57 in the analysis of the direction of rotation of the voltage according to FIGURE 5, according to the query step S607, it is checked whether the difference angles a, b, and c are equal to +120° ±50°. If not, then for each current sensor, i.e., for each phase, according to a loop arrangement referenced in step S608 in FIGURE 6b, an inversion of the respective phase current $I_X$ is carried out, as referenced in step S609. Then, once again, according to step S610, the difference angles a, b, and c will be calculated in the same manner as already indicated above, and, according to step S611, the query whether the difference angles are all different from -120° ±50° is repeated. If even only one of the difference angles is equal to said angle -120° or lies within the allocated margin, it will be recorded according to step S612 that the respective phase current $I_X$ was inverted and that the polarity of the current was changed. Then, the processing will be continued at step S606, and it will be indicated according to step S606A that the direction of rotation of the current is negative (despite the inversion of the respective phase current $I_X$ according to step S609).

If, however, it follows from the query according to step S611 that none of the difference angles a, b, and c lies within the angle range of -70° to -170°, it will be queried according to query step S613, similar to step S57 in the case of the analysis of the direction of rotation of the voltage according to FIGURE 5, whether each of the angles a, b, and c is equal to 120° ±50°, i.e., lies within the range of +70° to +170°. If this is not the case, an exit to step S615 is carried out via the loop node S614, according to which the direction of rotation of the current is set equal to X and the current allocation is set equal to X, whereupon a corresponding indication will be carried out according to step S615A, namely, that the direction of rotation of the current cannot be determined properly.

If, however, in the query step S613 the result is positive (exit Y), then the process continues with step S616, wherein it is recorded that the respective phase current $I_X$ was inverted and that the polarity of the current was changed. This means that an incorrect connection of, for instance, a current probe sensor 3 at the respective phase line was corrected automatically by inverting the corresponding phase current.

If, according to the calculation and query (step 613) the direction of rotation of the current in the three-phase system is acceptable, the direction of rotation for the current is stated as positive, as is indicated in step S617 in FIGURE 6b. It is also stated that the current allocation is acceptable, whereupon a corresponding indication that the direction of rotation for the current is positive will be effected in the display 21 according to step S617A according to FIGURE 1.

For the sake of completeness, it shall be noted here that in the diagrams according to FIGURE 2 to FIGURE 6 (as well as FIGURE 8 and FIGURE 9), correct processes or connections are always illustrated by solid lines in the flow, whereas incorrect connections or faulty connections are illustrated with broken lines (dotted or dashed lines).

In FIGURE 7, in the partial FIGURES 7a and 7b, by way of an example, there is schematically illustrated the composition of a three-phase system (FIGURE 7b) through individual symmetric components (FIGURE 7a), in order to illustrate the component analysis according to steps S7A to S7D in FIGURE 2.

According to FIGURE 7A, three components or phase sequences are illustrated, namely, a positive sequence P, a negative sequence N, and a zero sequence or mere displacement or offset Z (Z - Zero). The positive sequence P has phasors $A^+$, $B^+$, and $C^+$ in the correct order (wherein, in accordance with convention, vector diagrams always rotate in the counterclockwise direction, in accordance with the phase angle always increasing during time). The negative sequence N has phasors or phases in the order of $A^-$, $C^-$, and $B^-$. The zero sequence Z comprises three phasors $A^0$, $B^0$, and $C^0$ that are parallel to each other.

From the sequences P, N, and Z, an irregular system is composed according to FIGURE 7b, wherein the three symmetrical components are arranged as follows: It begins with the zero sequence Z ($A^0$, $B^0$, $C^0$), after which follows the positive sequence P ($A^+$, $B^+$, $C^+$), and finally the negative sequence N ($A^-$, $C^-$, $B^-$), as referenced by the arrows $A^0$ to $C^-$ in the diagram according to FIGURE 7b.

In a corresponding manner, conversely, the general system according to FIGURE 7b can be decomposed into symmetrical components according to FIGURE 7a.

This is a technique that has, in principle, been sufficiently known for decades and therefore needs no further explanation here.

Now, in a corresponding manner, according to steps S7A to S7D in FIGURE 2, the symmetrical components $U^+$, $U^-$, $I^+$, and $I^-$ (for the individual phases, respectively) will be set equal to $U_s$ or Is, and, in the following, the power analysis according to steps S8 and S9 in FIGURE 2, which is illustrated in more detail in FIGURE 8 and FIGURE 9, will be explained in more detail, on the one hand for a consumer system (FIGURE 8) and on the other hand for a generator system (FIGURE 9).

According to FIGURE 8, after an initial step S81, there will be calculated in a step S82 the phase angle $\overline{a}$ between the respective voltage and current component for each sequence P and N, i.e., for the positive-sequence component P and the negative-sequence component N. Thereupon it is checked in step S83 whether the phase angle $\overline{a}$ is equal to an angle of 10°, with a margin of ±40°. If this is true, the process directly proceeds to the final step S11 (see also FIGURE 2), i.e., the voltage and the current match. If, however, this check has a negative result, then in a subsequent step S84 it is checked whether the phase angle $\overline{a}$ corresponds to the angle 190°, with a margin of ±30°. If yes, then the current polarity is inverted according to step S85 in FIGURE 8, and the indication "polarity I = changed" is prepared. Afterward, the new allocation is displayed in step S11.

If, however, it is determined in step S84 that no inversion of the current is necessary (which means that the respective current probe has been mounted correctly on the phase line), it will be checked according to step S86 whether the phase angle $\overline{a}$ between current and voltage is equal to 130° ±40°. If this is true, the current allocation is changed according to step S87 in the manner indicated in FIGURE 8, and the process proceeds to the final step S11, wherein the new allocation is displayed.

Otherwise, according to step S88, another phase check is carried out, namely, whether the phase angle $\overline{a}$ is equal to 250° ±40°. If not, the process proceeds to the indication "No result" according to step S4D (see FIGURE 2). If, however, the phase angle $\overline{a}$ falls within the specified angle range, according to step S89 the current allocation will be changed, and in step S11 the new allocation of the current channels to the voltages will be indicated.

FIGURE 9 illustrates an approach for a case in which a generator system is connected to the three-phase mains system L1, L2, and L3, for instance, in the case of a photovoltaic system that supplies current to the mains.

After an initial step S91, the phase angle $\overline{a}$ between the respective voltage and the respective current for the positive-sequence/negative-sequence system components (see FIGURE 7) is calculated in step S92. Then, according to step S93, a check is made whether the phase angle $\overline{a}$ is equal to 190° ±40°. In contrast to FIGURE 8, here no current is drawn from the mains, but rather current is supplied to the mains, and therefore the comparison angle is increased by 180° compared to the power analysis in the case of the consumer system according to FIGURE 8.

If the phase angle $\overline{a}$ lies within the specified range, everything is acceptable, and the process will proceed to the final step S 11. If, however, this is not true, a check will be made according to step S94 whether there is an incorrect attachment of the respective current sensor 3, i.e., it will be queried whether the angle $\overline{a}$ is equal to 10° ±30°. If so, then the current direction will be inverted or the polarity of the current I will be changed according to step S95, and according to the final step S 11, the new allocation will be displayed.

If the result of the query according to step S94 is negative, an attachment of the current sensors at the correct phase will be checked, wherein, according to the query step S96, the phase angle $\overline{a}$ will be compared with a comparison angle 310° (±40°), and if this is true, then the current allocation will be exchanged according to the step S97 in FIGURE 9, and this change will be displayed accordingly as a new allocation, as referenced in step S 11.

If another phase interchange is given, according to step S98, the phase angle $\overline{a}$ will be compared with the angle 70° (±40° margin), and if the query result is positive, in a corresponding manner according to step S99, a current allocation, varied in comparison with step S97, is determined and the indication thereof is prepared, namely, that the current allocation was changed, as referenced in the final step S 11.

If, however, in step S98 the result is negative, no result can be determined, which will be displayed accordingly according to step S4D (see also FIGURE 2).

As already mentioned, the comparison angles in steps S93 to S98 according to FIGURE 9 are displaced by 180°, respectively, in contrast to the angles according to FIGURE 8, wherein a periodicity of 360° has to be taken into account: Thus, the angle 190° results from 10°+180°; 10° results from 190°+180°=370°, wherein 360° have to be deducted; 310° results from 130°+180°; and 70° results from 250°+180°, by subtracting 360°.

Moreover, the sequences or flows explained above by way of the diagrams according to FIGURE 2 to FIGURE 9 can be summarized in the following evaluation procedure:

1. If even only one voltage value in a phase is too low, the check of the voltage phase rotation and the power analysis cannot be carried out, and, therefore, a termination will be effected, and the voltage that is too low will be indicated on the display. Thereupon, the process proceeds to step No. 7.

2. If an invalid frequency is given, the check of the phase rotation and the power analysis also cannot be carried out. An invalid frequency status will be displayed, and the data processing will be terminated.

3. The check of the direction of rotation of the voltage will be carried out on the basis of the check of the phase angle differences (wye connection) with regard to 120° plus a margin.

4. If the direction of rotation is positive, the process proceeds to step No. 7.

5. If the direction of rotation is negative, the voltage allocation regarding the phases L2 and L3 is changed. The process thereafter proceeds to step No. 7.

6. If no valid direction of rotation can be determined (for instance, for angles outside the margin), only a current rotation can be checked, but no power analysis can be carried out.

7. If, in the current check it is determined that the value of the current in any phase is too low, no check of the current phase rotation and also no power analysis can be carried out. An indication is displayed that a current that is too low is present, and the algorithm is terminated.

8. The phase rotation in the current system is checked by checking the phase angle differences of the phase currents with respect to angles of 120° ($\pm$ bandwidth).

9. If the direction of rotation is positive, the process continues with step No. 12.

10. If the direction of rotation is negative, an exchange in the current allocation, namely, for the phases L1 and L3, is proposed, and the process proceeds to step No. 12.

11. If no valid status for the direction of rotation can be determined, the process will invert the polarity in the phase L1 or L2 or L3, one after the other, in order to thereupon once again check the rotation according to the preceding steps No. 9 and No. 10. If, by such an exchange, the direction of rotation becomes positive or negative, once again a corresponding polarity exchange of the corresponding current input is proposed.

12. If the direction of rotation of the voltage as well as the direction of rotation of the current are positive (namely, either from the beginning or due to a new allocation or a polarity change), the process continues to step No. 14.

13. In all other cases, an indication of an invalid allocation is displayed and the data processing is terminated.

14. The phase difference between current and voltage is checked according to the above explained diagrams, FIGURE 8, and FIGURE 9, with regard to a power analysis, wherein either all data are acceptable from the beginning and the status "OK" will be displayed, or, when the explained changes lead to a positive result, this will be displayed with the indication of the new allocation.

This will be carried out for a consumer system (in which current will be drawn from the mains) and for a generator system (in which current will be supplied to the mains).

15. Otherwise, as has already been mentioned above, an indication will be displayed, respectively, that no result is possible.

In principle, as a matter of course, the present measuring device 1 can also be used for conventional single-phase systems and so on, wherein the various checks set out above, with regard to the connection of sensors in a phase-correct manner and the possibility of the determination of a direction of rotation, might become unnecessary.

As disclosed herein, a given bandwidth in respect of a (measured/determined) phase angle and/or difference angle may be considered to be an error margin (or simply referred to as 'margin'), i.e. it may be considered to be a "defined maximum deviation from (e.g. a nominal value)".

The following section of the description consists of numbered paragraphs simply providing statements of the invention already described herein. The numbered paragraphs in this section are not claims. The claims are set forth below in the later section headed "claims".

1. A method for measuring electrical quantities, at least voltage and current, preferably also power, in three-phase systems (L1, L2, L3), wherein, for the three phases (L1, L2, L3), by means of voltage and current sensors (2; 3) the phase voltages ($U_{L1}$, $U_{L2}$, $U_{L3}$) and phase currents ($I_{L1}$, $I_{L2}$, $I_{L3}$) are sensed and corresponding voltage and current signals are evaluated in processing means (9) to form measurement data (D) which are displayed on display means (21), characterized in that by means of the processing means (9) the relative phase positions of the voltage signals ($U_{L1}$, $U_{L2}$, $U_{L3}$) as well as of the current signals ($I_{L1}$, $I_{L2}$, $I_{L3}$) in comparison with a given phase sequence and therefrom the correctness or incorrectness of the connections of the voltage and current sensors (2; 3) to the phase lines (L1, L2, L3) are determined, wherein corresponding display signals are output for the display means (21).

2. The method according to 1, characterized in that for the phase voltages ($U_{L1}$, $U_{L2}$, $U_{L3}$) and the phase currents ($I_{L1}$, $I_{L2}$, $I_{L3}$) a direction of rotation in the three-phase system is determined, respectively.

3. The method according to 2, characterized in that for the determination of the directions of rotation difference angles (a, b, c; a', b', c') between the individual phase voltages ($U_{L1}$, $U_{L2}$, $U_{L3}$) and phase currents ($I_{L1}$, $I_{L2}$, $I_{L3}$) are determined.

4. The method according to 3, characterized in that in the determination of the difference angles (a, b, c; a', b', c') a given bandwidth, e.g. $\pm$ 50°, is provided in connection with a phase comparison angle.

5. The method according to anyone of 1 through 4, characterized in that for each phase (L1, L2, L3) a power analysis is carried out on the basis of the voltage and current signals and by taking into account the respective phase sequences, wherein, preferably, for a power analysis, the phase angle between the voltage ($U_s$) and the current ($I_s$) is determined for each phase (L1, L2, L3), and/or wherein preferably the calculated power is displayed in connection with a corresponding phase sequence indication.

6. The method according to 5, characterized in that the power calculation is carried out depending on the fact whether a load or a generator operation is given (S10).

7. The method according to anyone of 1 through 6, characterized in that beforehand the sensed voltages ($U_{L1}$, $U_{L2}$, $U_{L3}$) and/or currents ($I_{L1}$, $I_{L2}$, $I_{L3}$) are compared with a given minimum threshold value and that they are evaluated only when said minimum threshold value is exceeded.

8. The method according to anyone of 1 through 7, characterized in that beforehand the sensed voltages and/or currents are checked with regard to the presence of a given system frequency (f).

9. The method according to anyone of 1 through 8, characterized in that, in case of a connection error, a correction in the sense of the inversion and/or exchange of individual or several phase connections will be carried out.

10. The method according to 9, characterized in that the correction is carried out electronically and automatically by means of the processing means.

11. The method according to anyone of 1 through 10, characterized in that for a power analysis the current flow direction for each phase is determined (S83, S93).

12. A device (1) for measuring electrical quantities, at least voltage and current, preferably also power, in three-phase systems (L1, L2, L3), comprising voltage and current sensors (2; 3) for sensing the phase voltages ($U_{L1}$, $U_{L2}$, $U_{L3}$) and the phase currents ($I_{L1}$, $I_{L2}$, $I_{L3}$), comprising processing means (9) which are supplied with corresponding voltage and current signals from the sensors (2; 3) and are arranged to process said signals into corresponding measurement data (D), and comprising display means (21) for displaying the measured values, characterized in that the processing means (9) are further arranged to determine the relative phase positions of the voltage signals ($U_{L1}$, $U_{L2}$, $U_{L3}$) as well as of the current signals ($I_{L1}$, $I_{L2}$, $I_{L3}$) in comparison with a given phase sequence and to determine therefrom the correctness or incorrectness of the connections of the voltage and current sensors (2; 3) to phase lines (L1, L2, L3), as well as to output corresponding display signals for the display means (21).

13. The device according to 12, characterized in that the processing means (9) are arranged to determine a respective direction of rotation in the three-phase system for the phase voltages ($U_{L1}$, $U_{L2}$, $U_{L3}$), and for the phase currents ($I_{L1}$, $I_{L2}$, $I_{L3}$).

14. The device according to 13, characterized in that the processing means (9) determine difference angles (a, b, c; a', b', c') between the individual phase voltages ($U_{L1}$, $U_{L2}$, $U_{L3}$) and the individual phase currents ($I_{L1}$, $I_{L2}$, $I_{L3}$) for the determination of the directions of rotation.

15. The device according to 14, characterized in that the processing means (9) provide a given bandwidth, e.g. $\pm$ 50°, in connection with a phase comparison angle for the determination of the difference angles (a, b, c; a', b', c').

16. The device according to anyone of 12 through 15, characterized in that the processing means (9) carry out a power calculation for each phase (L1, L2, L3) on the basis of the voltage and current signals and by taking into account the respective phase sequence, wherein preferably the display means (21) are driven so as to display the calculated power in connection with a corresponding indication of the phase sequence.

17. The device according to 16, characterized in that the power calculation is carried out in dependence on the fact whether a load or a generator operation is given (S10), and/or by determining the respective current flow direction for each phase.

18. The device according to anyone of 12 through 17, characterized in that the processing means (9) are arranged to compare the sensed voltages ($U_{L1}$, $U_{L2}$, $U_{L3}$) and/or currents ($I_{L1}$, $I_{L2}$, $I_{L3}$) with a given minimum threshold value beforehand, and to only carry out the evaluation thereof when said minimum threshold value is exceeded.

19. The device according to anyone of 12 through 18, characterized in that the sensed voltages and/or currents are checked beforehand with regard to the presence of a given system frequency (f).

20. The device according to anyone of 12 through 19, characterized by correcting means for the preferably automatic and electronic correction of a connection error in the sense of the inversion and/or exchange of individual and/or several phase measurement data.

Examples of the invention may provide a method for measuring electrical quantities, the method comprising sensing phase voltages and phase currents in phase lines of a three-phase system by way of voltage and current sensors connected to the phase lines, and evaluating, by a processor, voltage and current signals that correspond to the sensed phase voltages and phase currents, to form corresponding measurement data that are displayed on a display, wherein said evaluating includes: comparing, by way of the processor, relative phase positions of the voltage signals and the current signals with a given phase sequence, and based on said comparing, determining a correctness or incorrectness of the connections of the voltage and current sensors to the phase lines, wherein corresponding display signals are output to the display. Optionally, for the phase voltages and the phase currents, a respective direction of rotation in the three-phase system is determined. Optionally, for determining the directions of rotation, difference angles between the individual phase voltages and phase currents are determined. Optionally, in determining the difference angles, a given bandwidth (i.e. error margin) is provided in connection to a nominal phase angle of the three phase system. Optionally, for each phase, the method further comprises carrying out a power analysis based on the voltage and current signals and by taking into account the respective phase sequence, wherein a phase angle between the voltage and the current is determined for each phase. Optionally, the power analysis is carried out depending on whether a load or a generator operation is given. Optionally, beforehand the sensed phase voltages and/or phase currents are compared with a given minimum threshold value, and wherein the voltage signals and/or current signals are evaluated only when said minimum threshold value is exceeded. Optionally, beforehand the sensed phase voltages and/or phase currents are checked for a defined maximum deviation from the nominal system frequency. Optionally, in response to determining that one or more voltage or current sensors are incorrectly connected to the phase lines, a correction comprising an inversion and/or exchange of the measurement data of one or more phase lines is carried out. Optionally, the correction is carried out electronically and automatically by way of the processor. Optionally, the method further comprises a power analysis, and for the power analysis, a direction of current flow for each phase is determined.

Examples of the invention may also provide a device for measuring electrical quantities in three-phase systems, comprising: voltage and current sensors for sensing phase voltages and phase currents in phase lines of a three-phase system, a processor that is supplied with voltage and current signals from the voltage and current sensors, wherein the voltage and current signals correspond to the sensed phase voltages and phase currents, and wherein the processor is arranged to process said voltage and current signals into corresponding measurement data, and a display for displaying the measurement data, wherein the processor is further arranged to determine the relative phase positions of the voltage signals and the current signals and compare the relative phase positions with a given phase sequence, and based on the comparison, determine therefrom a correctness or incorrectness of the connections of the voltage and current sensors to the phase lines, and output corresponding display signals to the display. Optionally, the processor is arranged to determine a respective direction of rotation in the three-phase system for the phase voltages and the phase currents. Optionally, the processor is arranged to determine difference angles between the individual phase voltages and the individual phase currents for determining the directions of rotation. Optionally, a given bandwidth is provided in connection with a phase comparison angle for determining the difference angles. Optionally, the processor is arranged to carry out a power analysis for each phase based on the voltage and current signals and by taking into account the respective phase sequence. Optionally, the power analysis is carried out depending on whether a load or a generator operation is given. Optionally, the processor is arranged to compare the sensed phase voltages and/or phase currents with a given minimum threshold value beforehand, and to carry out the evaluation thereof only when said minimum threshold value is exceeded. Optionally, the processor is arranged to check the sensed phase voltages and/or phase currents beforehand for a defined maximum deviation from the nominal system frequency. Optionally, in response to determining that one or more voltage or current sensors are incorrectly connected to the phase lines, the processor is arranged to provide an automatic and electronic correction comprising inversion and/or exchange of the measurement data of one or more phase lines. Optionally, for each phase, the method further comprises carrying out a power analysis based on the voltage and current signals and by taking into account the respective phase sequence, and wherein a calculated power is displayed in connection with a corresponding phase sequence indication. Optionally, the display is driven so as to display a calculated power in connection with a corresponding indication of the phase sequence. Optionally, the power analysis includes determining a respective current flow direction for each phase.

**Claims**

1.  A method for measuring electrical quantities, the method comprising:

    sensing phase voltages and phase currents in phase lines of a three-phase system by way of voltage and current sensors connected to the phase lines; and
    evaluating, by a processor, voltage and current signals that correspond to the sensed phase voltages and phase currents, to form corresponding measurement data that are displayed on a display,
    wherein said evaluating includes:

    comparing, by way of the processor, relative phase positions of the voltage signals and the current signals with a given phase sequence; and
    based on said comparing, determining a correctness or incorrectness of the connections of the voltage and current sensors to the phase lines, wherein corresponding display signals are output to the display.

2.  The method according to Claim 1, wherein, for the phase voltages and the phase currents, a respective direction of rotation in the three-phase system is determined.

3. The method according to Claim 2, wherein, for determining the respective directions of rotation, difference angles between the individual phase voltages and phase currents are determined.

4. The method according to Claim 3, wherein, in determining the difference angles, a given margin is provided in connection with a nominal phase angle of the three-phase system.

5. The method according to any of Claims 1 to 4, wherein, for each phase, the method further comprises carrying out a power analysis based on the voltage and current signals and by taking into account the respective phase sequence, wherein a phase angle between the voltage and the current is determined for each phase; and/or wherein a calculated power is displayed in connection with a corresponding phase sequence indication.

6. The method according to Claim 5, wherein the power analysis is carried out depending on whether a load or a generator operation is given; optionally wherein the power analysis includes determining a respective current flow direction for each phase.

7. The method according to any of Claims 1 to 6, wherein beforehand the sensed phase voltages and/or phase currents are compared with a given minimum threshold value, and wherein the voltage signals and/or current signals are evaluated only when said minimum threshold value is exceeded.

8. The method according to any of Claims 1 to 7, wherein beforehand the sensed phase voltages and/or phase currents are checked for a defined maximum deviation from a nominal system frequency.

9. The method according to any of Claims 1 to 8, wherein, in response to determining that one or more voltage or current sensors are incorrectly connected to the phase lines, a correction comprising an inversion and/or exchange of the measurement data of one or more phase lines is carried out; optionally wherein the correction is carried out electronically and automatically by way of the processor.

10. The method according to any of Claims 1 to 10, wherein the method further comprises a power analysis, and for the power analysis, a direction of current flow for each phase is determined.

11. A device for measuring electrical quantities in three-phase systems, comprising:

voltage and current sensors for sensing phase voltages and phase currents in phase lines of a three-phase system;
a processor that is supplied with voltage and current signals from the voltage and current sensors, wherein the voltage and current signals correspond to the sensed phase voltages and phase currents, and wherein the processor is arranged to process said voltage and current signals into corresponding measurement data; and
a display for displaying the measurement data,
wherein the processor is further arranged to determine the relative phase positions of the voltage signals and the current signals and compare the relative phase positions with a given phase sequence, and based on the comparison, determine therefrom a correctness or incorrectness of the connections of the voltage and current sensors to the phase lines, and output corresponding display signals to the display.

12. The device according to Claim 11, wherein the processor is arranged to determine a respective direction of rotation in the three-phase system for the phase voltages and the phase currents; optionally wherein the processor is arranged to determine difference angles between the individual phase voltages and the individual phase currents for determining the directions of rotation.

13. The device according to Claim 12, wherein a given margin is provided in connection with a nominal phase angle for determining the difference angles.

14. The device according to any of Claims 11 to 13, wherein the processor is arranged to carry out a power analysis for each phase based on the voltage and current signals and by taking into account the respective phase sequence; optionally wherein the display is driven so as to display a calculated power in connection with a corresponding indication of the phase sequence.

15. The device according to Claim 14, wherein the power analysis is carried out depending on whether a load or a generator operation is given; optionally wherein the power analysis includes determining a respective current flow direction for each phase.

(L1) $U_{L1}$

(L2) $U_{L2}$

(L3) $U_{L3}$

(N) $U_N$

2   5

Ch1
Ch2
A/D-Conv.
ADS1174
4x16Bit
Ch3
Ch4

6

4

7

galvanic separation
data channels, clock

F + ADC voltage supply

8

galvanic separation of
the voltage supply of
the AID

CLK: 2.56MHz
sampling rate: 5kHz

DSP
TMS320C5504

9

CLK, CFG
DIN-U
SPLYCLK

Rogowski sensor/
current probe L1/L2/L3
range L1/L2/L3
SensorID L1/L2/L3
MUX

UART

CLK, CFG
DIN-I

RTC PWR

Reset

32.768kHz

17

11

13

$U_{RTC}$

19

EEPROM
(DSP-Code +
Calfactors)    calibration factors

serial process interface

SPI

D

GPIO

23

USB Host

SPI

USB Device    20

UART

LCD Controller
ARM Modul
64MB RAM
256MB Flash

DSP-Reset

Display
RGB    4.3in 480x272px
Truly TFT480272-13-E

21

D

key panel    22

Main Processor
(interface for display + key panel)

3

10

for integration

selection
Rogowski sensor/
current proble

(17)

14

(L1) $I_{L1}$    SensorID
L1

range L1

15

selection
Rogowski sensor/
current proble

14

(L2) $I_{L2}$    SensorID
L2

12

range L2

18

16

selection
Rogowski sensor/
current proble

14

(L3) $I_{L3}$    SensorID
L3

range L3

Ch1

Ch2

Ch3

A/D-Conv.
ADS1174
4x16Bit

1

Fig. 1

Fig. 2

```
                                      ┌──────────────────────┐         S1
                                      │  200ms measuring     │ ←─────
                                      │      interval        │
                                      └──────────────────────┘
                           ┌─────────────────┘        └─────────────────┐
                                                                                      S4A
      S2 ──┤  voltage       │ (Fig. 3)        │ current        │ (Fig. 4)    ┌─Signal
           │  validation    │          S3 ──  │ validation     │             │ too small
                                                                             S4B
                                                                             ┌─Invalid
      S5 ──┤ direction of rotation │ (Fig. 5)  │ direction of rotation │ (Fig. 6)  │ frequency
           │      voltage          │    S6 ─── │      current          │
                                                                             S4C
                                                                             ┌─Direction of
                                                                             │ rotation not
                                                                             │ determinable
      S7A            S7B             S7C             S7D
  (Fig. 7) │ symm. comp. │  │ symm. comp. │  │ symm. comp. │  │ symm. comp. │
           │ U ⇔ Us      │  │ U ⇔ Us      │  │ I ⇔ Is      │  │ I ⇔ Is      │

                                consumer operation              generator operation
                                          ◇ energy      S10
                                            flow

  (Fig. 8) │ consumer     │  S8            │ generator    │ (Fig. 9)    S4D
           │ system       │           S9── │ system       │             ┌─No result
                                                                        │ found

                              ┌─ OK / New ─┐
                              │ allocation │   S11
                              └────────────┘
```

Fig. 3

(S1)

S2

**Voltage Validation** — S21

Test: all $U_x$ > lower limit — S22

S23

N

OK?

Y

Test system frequency (f) — S25

S26

OK?

N

Y

S24 — < U

S28 — OK

S27 — No freq

(S5)

Fig. 4

(S1)

Current Validation — S31

S3

Test
all $I_x$ > lower limit — S32

OK ? — S33

N

Test
system frequency
(f) — S35

OK ? — S36

N

S34
< I

OK — S38

No
freq — S37

(S6)

(S2)

S5

Fig. 5

**Direction of Rotation of the Voltage** — S51

Initialization
direction of rotation U = X
allocation U = X — S52

calculation $a' = \varphi(U_1) - \varphi(U_2)$
calculation $b' = \varphi(U_2) - \varphi(U_3)$
calculation $c' = \varphi(U_3) - \varphi(U_1)$ — S53

S54
$a', b', c' = -120° \pm 50°$ ?

**Y**

**N**

S55
Exchange of allocation U
$U_2 \Leftrightarrow U_3$

S57
$a', b', c' = +120° \pm 50°$ ?

**N**

**Y**

S56
Set:
direction of rotation U = NEG
allocation U = exchanged

S59
Set:
direction of rotation U = POS
allocation U = OK

S58
Set:
direction of rotation U = X
allocation U = X

S56A
Rot U = NEG

S59A
Rot U = POS

S58A
Rot U = X

(S7B)

(S7A)

(S4C)

Fig. 6

Fig. 6a

S6

(S3)

Direction of
Rotation of the
Current — S601

Initialization
direction of rotation I = X
allocation I = X
polarity I = OK — S602

calculation a = $\varphi(I_1) - \varphi(I_2)$
calculation b = $\varphi(I_2) - \varphi(I_3)$
calculation c = $\varphi(I_3) - \varphi(I_1)$ — S603

Y

a,b,c =
-120°±50°
? — S604

N

Exchange of
allocation I
$I_1 \Leftrightarrow I_3$ — S605

a,b,c =
+120°±50°
? — S607

Y

N

(S606)

(S608)

(S607)

(Fig. 6b)

7/10
(Fig. 6a)
(S607)
N

(S605)

Y

S6

(S607)

Y

Fig. 6b

S608 — Loop
For x = 1 ... 3

S609 — Invert $I_x$

S610 — calculation a = $\varphi(I_1) - \varphi(I_2)$
calculation b = $\varphi(I_2) - \varphi(I_3)$
calculation c = $\varphi(I_3) - \varphi(I_1)$

S612

Set:
current [$I_x$] inverted
polarity I = changed

Y

S611

a,b,c =
-120°±50°
?

N

S616

Set:
current [$I_x$] inverted
polarity I = changed

Y

S613

a,b,c =
+120°±50°
?

N

S614

S606

Set:
direction of rotation I = NEG
allocation I changed

S617

Set:
direction of rotation I = POS
allocation I = OK

S615

Set:
direction of rotation I = X
allocation I = X

S606A

**Direction of Rotation I
= NEG**

S617A

**Direction of Rotation I
= POS**

S615A

**Direction of Rotation I
= X**

Fig. 7

Fig. 7a

Fig. 7b

Fig. 8

(S10)

S8

**Consumer System** — S81

Positive-sequence/negative-sequence system components of the direction of rotation
Calculate $\bar{a} = \varphi(U_s) - \varphi(I_s)$ — S82

S83

Y

$\bar{a} = 10° \pm 40°$ ?

N

S85

Invert the current polarity $[I_1, I_2, I_3]$
polarity I = changed

Y

S84

$\bar{a} = 190° \pm 30°$ ?

N

S87

Rotate current allocation
$I_1 \Rightarrow I_2, I_2 \Rightarrow I_3, I_3 \Rightarrow I_1$
allocation I = changed

Y

S86

$\bar{a} = 130° \pm 40°$ ?

N

S89

Rotate current allocation
$I_1 \Rightarrow I_3, I_2 \Rightarrow I_1, I_3 \Rightarrow I_2$
allocation I = changed

Y

S88

$\bar{a} = 250° \pm 40°$ ?

N

OK / New allocation — S11

(Fig. 2)

No result — S4D

(Fig. 2)

# EP 2 848 947 A1

Fig. 9

(S10)

**Generator System** — S91

Positive-sequence/negative-sequence system components of the direction of rotation
Calculate $\bar{a} = \varphi(U_2) - \varphi(I_2)$ — S92

S9

**S93**
$\bar{a} = 190° \pm 40°$ ?

**Y** (OK)

**N**

**S94**
$\bar{a} = 10° \pm 30°$ ?

**Y** — S95
Invert the current direction polarity [$I_1$, $I_2$, $I_3$]
polarity I = changed

**N**

**S96**
$\bar{a} = 310° \pm 40°$ ?

**Y** — S97
Exchange the current allocation $I_1 \Leftrightarrow I_2$, $I_2 \Leftrightarrow I_3$, $I_3 \Leftrightarrow I_1$
allocation I = changed

**N**

**S98**
$\bar{a} = 70° \pm 40°$ ?

**Y** — S99
Exchange the current allocation $I_1 \Leftrightarrow I_3$, $I_2 \Leftrightarrow I_1$, $I_3 \Leftrightarrow I_2$
allocation I = changed

**N**

**OK / New allocation** — S11

**No result** — S4D

24

Europäisches
Patentamt

European
Patent Office

Office européen
des brevets

## EUROPEAN SEARCH REPORT

Application Number

EP 14 18 4664

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 7 660 776 B1 (KIOUS KENNEBEC MILES [US]) 9 February 2010 (2010-02-09) * the whole document * | 1-15 | INV.<br>G01R19/25<br>G01R29/18 |
| X,P | EP 2 731 220 A1 (SCHNEIDER ELECTRIC IND SAS [FR]) 14 May 2014 (2014-05-14) * abstract; figures 1-2b * * paragraphs [0014], [0032] - [0034], [0039], [0042] - [0047], [0049] - [0051], [0053] - [0054]; claims 1-14 * | 1-15 | |
| X | US 5 561 376 A (MOORE ROBERT E [US] ET AL) 1 October 1996 (1996-10-01) * the whole document * | 1-15 | |
| A | WO 98/18013 A2 (ABB POWER T & D CO [US]; HUBBARD VICK A [US]; MUNDAY MARK L [US]; HEMM) 30 April 1998 (1998-04-30) * abstract; figures 1-17 * | 1-15 | |

TECHNICAL FIELDS
SEARCHED      (IPC)

G01R

The present search report has been drawn up for all claims

| Place of search | Date of completion of the search | Examiner |
|---|---|---|
| Berlin | 30 January 2015 | Binger, Bernard |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

**ANNEX TO THE EUROPEAN SEARCH REPORT
ON EUROPEAN PATENT APPLICATION NO.**

EP 14 18 4664

This annex lists the patent family members relating to the patent documents cited in the above-mentioned European search report.
The members are as contained in the European Patent Office EDP file on
The European Patent Office is in no way liable for these particulars which are merely given for the purpose of information.

30-01-2015

| Patent document cited in search report | | | Publication date | Patent family member(s) | | | Publication date |
|---|---|---|---|---|---|---|---|
| US 7660776 | B1 | | 09-02-2010 | NONE | | | |
| EP 2731220 | A1 | | 14-05-2014 | BR | 102013028604 | A2 | 21-10-2014 |
| | | | | CN | 103809010 | A | 21-05-2014 |
| | | | | EP | 2731220 | A1 | 14-05-2014 |
| | | | | FR | 2998061 | A1 | 16-05-2014 |
| US 5561376 | A | | 01-10-1996 | US | 5514969 | A | 07-05-1996 |
| | | | | US | 5561376 | A | 01-10-1996 |
| | | | | US | 5631569 | A | 20-05-1997 |
| WO 9818013 | A2 | | 30-04-1998 | AR | 008894 | A1 | 23-02-2000 |
| | | | | AR | 026659 | A1 | 19-02-2003 |
| | | | | AR | 026660 | A1 | 19-02-2003 |
| | | | | AR | 026661 | A1 | 19-02-2003 |
| | | | | AR | 026662 | A1 | 19-02-2003 |
| | | | | AU | 736045 | B2 | 26-07-2001 |
| | | | | AU | 4818397 | A | 15-05-1998 |
| | | | | BR | 9712557 | A | 28-12-1999 |
| | | | | CA | 2269499 | A1 | 30-04-1998 |
| | | | | CN | 1234120 | A | 03-11-1999 |
| | | | | EP | 1018022 | A2 | 12-07-2000 |
| | | | | EP | 2088437 | A1 | 12-08-2009 |
| | | | | RO | 120431 | B1 | 30-01-2006 |
| | | | | US | 6094622 | A | 25-07-2000 |
| | | | | US | 6269316 | B1 | 31-07-2001 |
| | | | | US | 6374188 | B1 | 16-04-2002 |
| | | | | US | 6507794 | B1 | 14-01-2003 |
| | | | | US | 6577961 | B1 | 10-06-2003 |
| | | | | WO | 9818013 | A2 | 30-04-1998 |

EPO FORM P0459

For more details about this annex : see Official Journal of the European Patent Office, No. 12/82